# EUROPEAN PATENT APPLICATION

(11) **EP 4 624 623 A1**
(43) Date of publication of application: **01.10.2025**
(21) Application number: 24743647.0
(22) Date of filing: 29.03.2024
(51) Int. Cl.: C23C 14/04

(54) **METAL MASK FOIL MATERIAL, AND MANUFACTURING METHOD AND MANUFACTURING DEVICE THEREFOR**

(30) Priority: 06.02.2024 CN 202410168347
(71) Applicant: Jiangsu Topto Materials Co., Ltd., Zhenjiang, Jiangsu 212499 (CN)
(72) Inventor: ZHANG, Caixing, Zhenjiang, Jiangsu 212499 (CN); QIAN, Chao, Zhenjiang, Jiangsu 212499 (CN); GAN, Shuaiyan, Zhenjiang, Jiangsu 212499 (CN); WANG, Ya, Zhenjiang, Jiangsu 212499 (CN)
(74) Representative: karo IP
(86) International application number: PCT/CN2024/084650
(87) International publication number: WO 2025/166886

(57) **Abstract**

The present invention provides metal mask foil, a manufacturing method thereof, and a manufacturing device thereof. The metal mask foil includes at least two pieces of sub-foil, where the pieces of sub-foil are disposed side by side in a width direction, and long edges in contact between two adjacent pieces of sub-foil are welded together; and a target width T of the metal mask foil and an average value t of initial widths of the pieces of sub-foil meet: T/n ≤ t < T, n being a quantity of the pieces of sub-foil that form the metal mask foil. In technical solutions of the present disclosure, raw foil pieces of a conventional width are joined together by welding to manufacture metal mask foil of a larger width, which avoids technical bottlenecks such as limitation by equipment on production of a metal mask of a large width by conventional continuous casting and rolling, causing huge invested costs, and a bad shape of an edge of a raw material caused by a larger width of the raw material, thereby implementing low-cost and high-quality production of metal mask foil of a large width.

## Description

### TECHNICAL FIELD

The present invention relates to the field of metal mask technologies, and in particular, to metal mask foil, a manufacturing method thereof, and a manufacturing device thereof.

### BACKGROUND

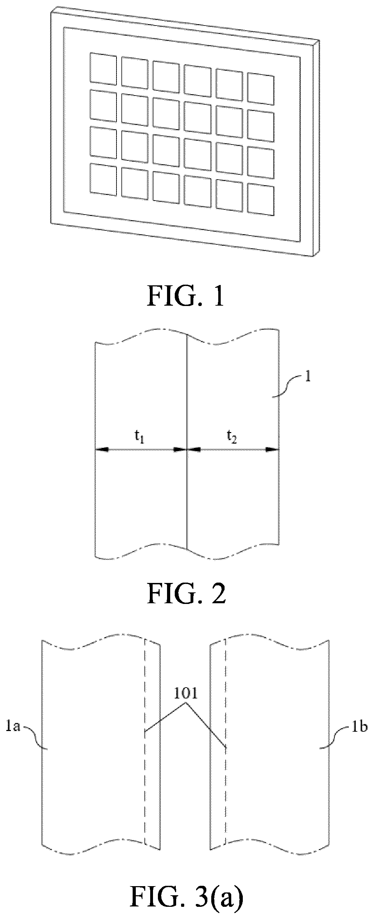

A metal mask is an important tool for an AMOLED display panel in a manufacturing process, and is mainly configured to limit a deposition region of a film-layer material in a vapor deposition process of an organic material. Based on deposition of different types of film layers, metal masks may be classified into three categories: a fine metal mask (FMM), a common metal mask (CMM), and an encapsulation-layer metal mask (CVD Mask). Both a body of the CMM and a body of the CVD Mask consist of two parts: a metal mask frame and a whole mask mesh that are combined as shown in FIG. 1. The mesh part has openings for fixed positions provided on a whole metal raw material through steps such as exposure and etching, to limit material deposition as above.

Currently, a whole metal raw material used for mass production on a G6H line usually has a width of about 1 m. With the rise of large-generation (G8.5 and above) AMOLED production lines, a metal mask of a larger size is required, which requires relevant industries to prepare a metal raw material of a larger width. However, a whole large-size metal raw material cannot be prepared correspondingly due to size limitation of existing raw-material rolling equipment, addition of dedicated wide rolling equipment leads to extremely high investment amounts, and a larger width of a raw material is more likely to result in a bad shape of an edge (commonly known as "edge wave") of the raw material.

The above factors undoubtedly limit development of the AMOLED industries to higher generation lines. How to prepare a large-size metal raw material at low costs becomes a problem to be resolved urgently.

### SUMMARY

To resolve or ameliorate the technical problem that exists in the related art, according to a first aspect of the present disclosure, metal mask foil is provided. The metal mask foil may be at least for manufacturing a metal mask used in OLED panel production. The metal mask foil includes:
at least two pieces of sub-foil, where the pieces of sub-foil are disposed side by side in a width direction, and long edges in contact between two adjacent pieces of sub-foil are welded together; and
a target width T of the metal mask foil and an average value t of initial widths of the pieces of sub-foil meet: T/n ≤ t < T, n being a quantity of the pieces of sub-foil that form the metal mask foil.

For the metal mask foil in the foregoing solution, a plurality of pieces of sub-foil of a small width are joined together by welding to form wide foil of a target width, which avoids technical bottlenecks such as limitation by equipment on production of a metal mask of a large width by conventional continuous casting and rolling, causing huge invested costs, and a bad shape of an edge of a raw material caused by a larger width of the raw material, thereby implementing low-cost and high-quality production of metal mask foil of a large width.

As one of optional solutions, the target width T of the metal mask foil is greater than or equal to 1 m, and a thickness is 0.02-0.5 mm.

As one of optional solutions, the metal mask foil is made of Invar36, SUS420, or SUS304, and is in a form of a sheet, a strip, or a coil.

According to a second aspect of the present disclosure, a method for manufacturing the metal mask foil described in the first aspect is provided and includes:
taking at least two pieces of sub-foil;
cutting off an edge wave part of at least one long edge of each piece of sub-foil;
joining the pieces of sub-foil together along long edges, where the pieces of sub-foil are disposed side by side in a width direction and are joined tightly with no gap therebetween;
performing welding at each joining seam to form one whole piece of foil; and
cutting off excess parts of two long edges of the whole foil, to reach the target width T.

As one of optional solutions, if two long edges of sub-foil that forms a middle part of the whole foil and a long edge that is close to an inner side and that is of sub-foil that forms an edge part of the whole foil have edge waves, the edge waves are precut off before joining; and
if a long edge that is close to an outer side and that is of the sub-foil that forms the edge part of the whole foil has an edge wave, the edge wave is precut off before joining or is cut off after welding.

As one of optional solutions, the joining seam is inspected before welding to ensure good joining at the joining seam.

As one of optional solutions, the welding step is implemented by one or more of laser welding, electron beam welding, resistance welding, and argon arc welding.

According to a third aspect of the present disclosure, a device for manufacturing the metal mask foil described in the first aspect is provided and includes:
a welding carrier, provided with a clearance in a middle part for keeping space during welding;
alignment mechanisms, where a plurality of alignment mechanisms are arranged on two sides of the welding carrier and are configured to push pieces of sub-foil toward each other for joining, to ensure a tightly joining seam located exactly at the clearance;
a fitting component, configured to fit the pieces of sub-foil to a surface of the welding carrier, to ensure that the pieces of sub-foil are flush with each other in a thickness direction;
an inspection lens, configured to inspect a joining state at the joining seam; and
a welding heat source, configured to weld the pieces of sub-foil.

As one of optional solutions, flatness of the welding carrier is less than or equal to 0.05 mm; and
a width of the clearance is 1-5 mm.

As one of optional solutions, the fitting component includes one or more of at least the following components:
a press roll, disposed on the welding carrier;
magnets, disposed in the welding carrier and distributed on at least two sides of the clearance; and
a vacuum device, disposed in the welding carrier and configured to provide a negative-pressure environment between the pieces of sub-foil and the surface of the welding carrier.

Based on the above, the technical solutions according to the foregoing aspects and the optional solutions thereof remove constraints imposed by existing processing methods on development of a production process of metal mask foil of a large width to higher-generation lines (G8.5 and above). This can implement low-cost production of large-width foil suitable for a metal mask on high-generation lines, and can also achieve technical effects of having same quality as that of metal mask foil manufactured by continuous casting and rolling.

In addition, some of other additional aspects and advantages of the present disclosure are given in the following description, and some become apparent from the following description or are learned through practice of the present disclosure.

### BRIEF DESCRIPTION OF THE DRAWINGS

To describe technical solutions in embodiments of the present invention or in the background more clearly, the following describes accompanying drawings used in the embodiments of the present invention or in the background.
FIG. 1 is a schematic diagram of a structure of a CMM and a CVD Mask in the related art;
FIG. 2 is a schematic diagram of a structure of metal mask foil according to the present invention;
FIG. 3 is schematic diagrams of processing in manufacturing steps of metal mask foil according to the present invention;
FIG. 4 is a schematic diagram of processing of middle sub-foil when metal mask foil according to the present invention includes three or more pieces of sub-foil;
FIG. 5 is a schematic diagram of a structure of three pieces of sub-foil included in metal mask foil according to the present invention;
FIG. 6 is a schematic diagram of welding and winding of metal mask foil according to the present invention;
FIG. 7 is a schematic diagram of a device for manufacturing metal mask foil according to the present invention; and
FIG. 8 is a schematic diagram of a device for manufacturing metal mask foil according to the present invention.

Reference numbers in the figures:
1/1a/1b/1c: Sub-foil; 11: Weld; 101/102/103: Cutting line;
2: Welding carrier; 21: Magnet; 201: Clearance;
3: Alignment mechanism; 4: Press roll; 5: Inspection lens; and 6: Welding heat source.

### DETAILED DESCRIPTION

To make objectives, technical solutions, and advantages of the present invention clearer, the following further describes the present invention in detail with reference to the accompanying drawings. Apparently, the described embodiments below are merely some rather than all of the embodiments of the present invention. For reference, the following described matters and the accompanying drawings are brief examples that help understand the present invention, and are not intended to limit the technical scope of the present invention. In other words, the embodiments described below may have various transformations that are within the scope of the technical ideas of the present invention, and a person of ordinary skill in the technical field to which the present invention belongs may easily understand the technical ideas of the present invention by the following description. The following further describes the present invention with reference to the accompanying drawings and the embodiments.

Currently, limited by production equipment, processes, costs, and other factors, a whole raw foil piece for mass production has an insufficient width, which can only be used for manufacturing a whole metal mask (CMM or CVD Mask) adapted to a G6H or lower line, but cannot be meet a requirement for a width of metal mask foil for large-generation lines such as G8.5 and above.

In view of this, an embodiment of the present disclosure provides metal mask foil, to provide low-cost, high-quality, and large-width metal mask foil to meet a requirement for a large width of metal mask foil for producing, at low costs, a whole metal mask adapted to large-generation lines such as G8.5 and above. As shown in FIG. 2, the metal mask foil specifically includes:
sub-foil 1, which may be metal mask raw foil of a conventional width in the related art. Raw foil with no edge wave on two long flat edges or raw foil with an edge wave of an acceptable undulation degree on two long edges may be directly used as the sub-foil 1. When raw foil with an edge wave is used as the sub-foil 1, the edge wave on two sides needs to be cut off to ensure that produced metal mask foil has a good shape.

The metal mask foil provided in this embodiment of the present disclosure includes at least two pieces of sub-foil 1. The pieces of sub-foil 1 are disposed side by side in a width direction, and long edges in contact between two adjacent pieces of sub-foil 1 are welded together, to form one whole piece of foil of a larger width.

The metal mask foil provided in the present disclosure has a target width T. An average value t of initial widths of the pieces of sub-foil 1 that form the metal mask foil and the target width T meet: T/n ≤ t < T, n being a quantity of the pieces of sub-foil 1 that form the metal mask foil. In other words, the pieces of sub-foil 1 welded together may directly form large-width foil of the target width, or may form large-width foil of a width that exceeds the target width, and then parts that exceed the target width on two sides of the large-width foil are cut off to reach the target width. For example, as shown in FIG. 2, widths of retained parts of two pieces of sub-foil 1 that form the metal mask foil in the figure are respectively t₁ and t₂, where t₁ + t₂ = T. In this case, an initial width of raw foil used as the sub-foil 1 should be greater than or equal to the width of the finally retained part of the sub-foil 1.

It should be understood that regardless of the manner of reaching the target width of the metal mask foil provided in the present disclosure, it should be ensured that the final metal mask foil has a flat shape of the middle and edge or has a shape that meets a requirement of a metal mask for flatness of the raw foil.

The target width of the metal mask foil provided in the present disclosure is greater than or equal to 1 m, and the target width is a final width of this foil product. For example, the width may be 1.2 m, 1.5 m, 1.7 m, 2 m, 2.5 m, or the like. A thickness of the metal mask foil in the present disclosure is 0.02-0.5 mm. For example, the thickness may be 0.03 mm, 0.05 mm, 0.1 mm, 0.15 mm, 0.2 mm, 0.3 mm, or the like. A thickness of the used sub-foil 1 is consistent with the thickness of the final foil product.

In an optional embodiment, considering a magnetic requirement in an actual application scenario, the metal mask foil provided in the present disclosure may be made of Invar36, SUS420, or SUS304.

In an optional embodiment, a product of the metal mask foil provided in the present disclosure may be a sheet, a strip, or a coil. The sheet is a metal mask foil product with a length-width ratio less than or equal to 5. The strip is a metal mask foil product with a length-width ratio greater than 5. The coil is a metal mask foil roll material formed by winding a sheet or a strip by a winding machine.

In a typical embodiment, the metal mask foil in the present disclosure is manufactured through the following steps:
Step 1: Take at least two pieces of sub-foil 1.

The selected sub-foil 1 is metal mask raw foil of a conventional width in the related art, and may be a sheet, a strip, or a coil. A thickness of the raw foil is selected based on a thickness of the metal mask foil to be manufactured, and the two thicknesses should be consistent.

Step 2: Cut off an edge wave part of at least one long edge of each piece of sub-foil 1.

A premise for performing the operation of cutting off the edge wave part in this step is that two long edges of the sub-foil 1 have edge waves of an unacceptable undulation degree. In other words, if the two long edges of the sub-foil 1 do not have edge waves of an unacceptable undulation degree, the step of cutting off the edge wave part may not be performed. Therefore, the foregoing two cases should be considered as implementations included in step 2.

Step 3: Join the pieces of sub-foil 1 together along long edges, where the pieces of sub-foil 1 are disposed side by side in a width direction and are joined tightly with no gap therebetween.

During joining, if an edge wave part of one edge of the sub-foil 1 is not cut off, and the edge wave part has an unacceptable undulation degree, the sub-foil 1 should be joined on the outermost side, and the edge with the edge wave part is used as an outer edge of a whole obtained through joining, to ensure flatness of a middle part of foil obtained through joining.

Step 4: Perform welding at each joining seam to form one whole piece of foil.

Step 5: Cut off excess parts of two long edges of the whole foil, to reach the target width T.

If there is still an edge wave part of an unacceptable undulation degree on the two long edges of the whole foil after welding, at least all of the edge wave part should be cut off in this step, to ensure that flatness or an undulation degree of a shape of an edge of a final product is acceptable.

As a preferred implementation, if two long edges of sub-foil 1 that forms a middle part of the whole foil and a long edge that is close to an inner side and that is of sub-foil 1 that forms an edge part of the whole foil have edge waves, the edge waves are precut off before joining. In other words, if edges of a piece of sub-foil 1 and another piece of sub-foil 1 that are to be joined together have edge waves, the edge waves of the edges for joining should be precut off before joining, to ensure flatness of a shape at a seam.

In an optional embodiment, if a long edge that is close to an outer side and that is of the sub-foil 1 that forms the edge part of the whole foil has an edge wave, the edge wave is precut off before joining or is cut off after welding. It is to be noted that if the edge wave is precut off, during joining, widths of all the pieces of sub-foil 1 should be ensured to be at least not less than the target width T.

In an optional embodiment, the joining seam is inspected before welding to ensure good joining at the joining seam. Reference factors for determining whether the joining is good should include at least whether there is poor contact at the joining seam in an extension direction that leads to light transmission.

In an optional embodiment, the welding step is implemented by one or more of laser welding, electron beam welding, resistance welding, and argon arc welding.

As targeted below, the present disclosure provides a specific embodiment of the metal mask foil.

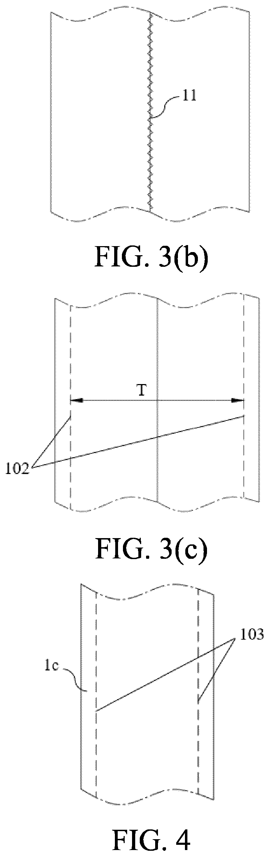

As shown in FIG. 2, the metal mask foil in this embodiment includes two pieces of sub-foil 1 with respective widths of t₁ and t₂. The two pieces of sub-foil 1 have the same thickness and are made of the same material. The material is selected from Invar36, SUS420, or SUS304. The thickness is 0.02-0.5 mm. As shown in FIG. 3, steps of manufacturing the metal mask foil are as follows:
Step 1: Select two pieces of sub-foil 1, and mark the two pieces of sub-foil 1 respectively as sub-foil 1a and sub-foil 1b, as shown in FIG. 3(a). An initial width of the sub-foil 1a is greater than t₁, and an initial width of the sub-foil 1b is greater than t₂.
Step 2: As shown in FIG. 3(a), cut off edge parts of the sub-foil 1a and the sub-foil 1b respectively along cutting lines 101, to form new edges along the cutting lines 101. In addition, after cutting off this time, the width of the sub-foil 1a is still greater than t₁, and the width of the sub-foil 1b is still greater than t₂.
Step 3: Join the sub-foil 1a and the sub-foil 1b together along the cutting lines 101, and then inspect a joining seam to ensure good and tight joining at the joining seam with no gap.
Step 4: Weld the sub-foil 1a and the sub-foil 1b at the joining seam therebetween to form a weld 11 shown in FIG. 3(b), so that the sub-foil 1a and the sub-foil 1b form one whole piece of foil.
Step 5: As shown in FIG. 3(c), cut off excess parts of two edges of the whole foil respectively along cutting lines 102 on the two edges of the whole foil obtained in the foregoing step, where a width of a retained part is the target width T, and T = t₁ + t₂, to obtain the metal mask foil of a large width in the present disclosure.

As targeted below, another specific embodiment of the metal mask foil is provided.

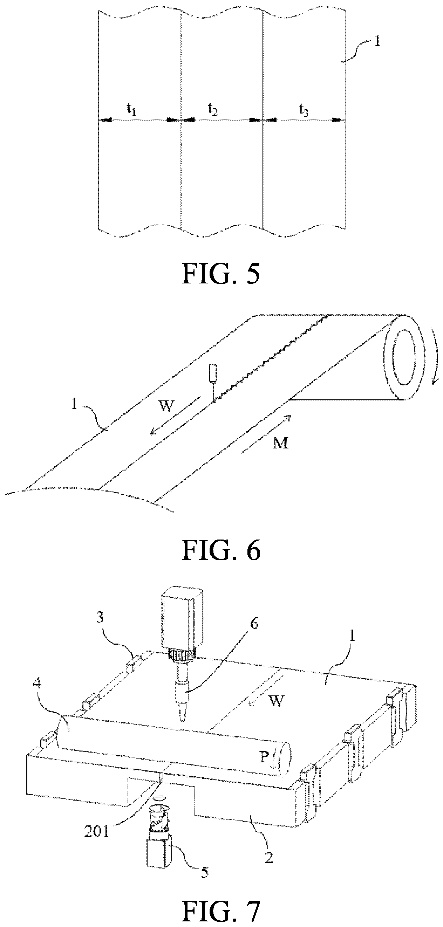

A difference between this specific embodiment and the foregoing specific embodiment lies in that the metal mask foil in this specific embodiment includes three pieces of sub-foil 1 with respective widths of t₁, t₂, and t₃, as shown in FIG. 5. Steps of manufacturing the metal mask foil are as follows:
Step 1: Select three pieces of sub-foil 1, and mark the three pieces of sub-foil 1 respectively as sub-foil 1a, sub-foil 1b, and sub-foil 1c, as shown in FIG. 3(a) and FIG. 4. An initial width of the sub-foil 1a is greater than t₁, an initial width of the sub-foil 1c is greater than t₂, and an initial width of the sub-foil 1b is greater than t₃.
Step 2: As shown in FIG. 3(a), cut off the edge parts of the sub-foil 1a and the sub-foil 1b respectively along the cutting lines 101, and as shown in FIG. 4, cut off edge parts of the sub-foil 1c along cutting lines 103 on two sides.

After cutting off, new edges of the sub-foil 1a and the sub-foil 1b are formed respectively along the cutting lines 101, and new edges of the sub-foil 1c are formed along the cutting lines 103. In addition, after cutting off this time, the width of the sub-foil 1a is still greater than t₁, the width of the sub-foil 1b is still greater than t₃, and the width of the sub-foil 1c is equal to t₂.

Step 3: Sequentially join the sub-foil 1a, the sub-foil 1b, and the sub-foil 1c together in a width direction. The sub-foil 1a and the sub-foil 1b are joined respectively on two sides of the sub-foil 1c. Edges that are not cut off in the foregoing step and that are of the sub-foil 1a and the sub-foil 1b are used as outer edges on two sides obtained through joining. Then, inspect joining seams to ensure good and tight joining at the joining seams with no gap.

Step 4: Weld the sub-foil 1a, the sub-foil 1b, and the sub-foil 1c at the joining seams therebetween, so that the sub-foil 1a, the sub-foil 1b, and the sub-foil 1c form one whole piece of foil.

Step 5: Cut off excess parts of two edges of the whole foil obtained in the foregoing step, where a width of a retained part is the target width T, widths of retained parts of the sub-foil 1a and the sub-foil 1b are respectively t₁ and t₃, and T = t₁ + t₂ + t₃, to obtain the metal mask foil of a large width in the present disclosure.

In this specific embodiment, when step 3 and step 4 are performed, the sub-foil 1a and one side of the sub-foil 1c may be first joined and welded together, and the sub-foil 1b and the other side of the sub-foil 1c may be then joined and welded together.

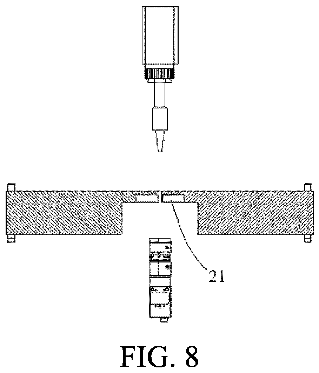

In a typical embodiment, the metal mask foil in the present disclosure is manufactured by using the following device. As shown in FIG. 7 and FIG. 8, a device for manufacturing the metal mask foil includes the following components:
A welding carrier 2 is configured to carry the sub-foil 1 during welding, and is provided with a clearance 201 in a middle part for keeping space during welding. In a specific embodiment, as shown in FIG. 7, the welding carrier 2 includes two sub-carriers, and the clearance 201 is a gap reserved between the sub-carriers. In some implementations, a plurality of sub-carriers may be disposed based on a quantity of sub-foil pieces to be welded, to ensure that a quantity of sub-carriers is consistent with a quantity of sub-foil pieces.

A plurality of alignment mechanisms 3 are arranged on two sides of the welding carrier 2 and are configured to push two pieces of sub-foil 1 toward each other for joining, to ensure a tightly joining seam located exactly at the clearance 201. In a specific embodiment, an alignment mechanism 3 includes a pushing block and a power unit that drives the pushing block to move, and the power unit may be a motor, a cylinder, or the like. Only the pushing block is shown in FIG. 7.

A press roll 4 is configured to press the sub-foil 1 against the welding carrier 2 to fit the sub-foil 1 to a surface of the welding carrier 2, to ensure that pieces of the sub-foil 1 are flush with each other in a thickness direction. In a specific embodiment, the press roll 4 is an unpowered free roll. In this case, the sub-foil 1 is driven by an external force to move. For example, as shown in FIG. 6, an external force that drives the sub-foil 1 to move is generated by winding the foil using a winding machine. In addition, in another specific embodiment, the press roll 4 is a driving roll driven by a power mechanism. Only the press roll 4 is shown in FIG. 7. The power mechanism is a roll-driving mechanism in the related art, and details are not described herein. In FIG. 6 and FIG. 7, a direction M is a movement direction of the sub-foil 1, a direction W is a welding direction, and a direction P is a rotation direction of the press roll 4.

An inspection lens 5 is configured to inspect a joining state at the joining seam. For example, before welding, whether a joining seam is tight is inspected, and whether an abnormality that may affect a welding effect, for example, sheet deformation, exists at a seam position is inspected. In a specific embodiment, the inspection lens 5 is disposed at a position facing the clearance 201, and whether there is light leakage at a seam position is inspected through the clearance 201, to determine whether the sub-foil 1 is well joined.

A welding heat source 6 is configured to weld the pieces of sub-foil 1. In a specific embodiment, one or more of heat source devices for laser welding, electron beam welding, resistance welding, and argon arc welding may be used as the welding heat source 6. In a specific embodiment, the press roll 4 and the welding heat source 6 may be combined, so that a tight pressing position is as close as possible to a welding region to flatten the sub-foil 1 at a welding position, and a length of the press roll 4 should be at least greater than a width of the clearance 201 on the welding carrier 2.

In an optional embodiment, to ensure a welding effect, flatness of the welding carrier 2 should be ensured to be within 0.05 mm, and a width of the clearance 201 should be 1-5 mm.

Based on the device for manufacturing the metal mask foil, a welding operation includes the following steps:
Step 1: Loading: Lay to-be-welded sub-foil 1 pieces flat on the welding carrier 2, where the sub-foil 1 pieces are joined and suspended at the clearance 201.
Step 2: Alignment: Activate the alignment mechanism 3 to align the sub-foil 1 pieces at a seam.
Step 3: Fitting: Perform tight pressing locally at the seam using the press roll 4.
Step 4: Inspection: Start the inspection lens 5 to inspect whether there is light leakage at the seam, to determine whether the sub-foil 1 pieces are well joined.
Step 5: Welding: Activate the welding heat source 6 to weld the sub-foil 1 pieces along the seam from one end to the other end to complete welding.

In another typical embodiment, a difference from the foregoing embodiment lies in that, in the device for manufacturing the metal mask foil in the present disclosure, the sub-foil 1 pieces are laid flat on the welding carrier 2 and do not move, the press roll 4, the inspection lens 5, and the welding heat source 6 are movable along a seam between the sub-foil 1 pieces, and the press roll 4 may be driven by a driving device to perform a downward pressing action. The driving device that drives movement and downward pressing is an existing technique, and details are not described herein. A welding operation includes the following steps:
Step 1: Loading: Lay to-be-welded sub-foil 1 pieces flat on the welding carrier 2, where the sub-foil 1 pieces are joined and suspended at the clearance 201.
Step 2: Alignment: Activate the alignment mechanism 3 to align the sub-foil 1 pieces at a seam.
Step 3: Inspection before welding: Inspect, using the inspection lens 5, whether there is light leakage at the seam of the sub-foil 1 pieces from one end to the other end, to determine whether the sub-foil 1 pieces are well joined.
Step 4: Welding: Perform tight downward pressing locally at the seam using the press roll 4, and synchronously move the welding heat source 6 and the press roll 4 in a welding direction to weld the sub-foil 1 pieces along the seam from one end to the other end to complete welding.

In another typical embodiment, a difference from the foregoing embodiment lies in that, in the device for manufacturing the metal mask foil in the present disclosure, the press roll 4 in the foregoing embodiment is replaced with magnets 21. The magnets 21 are disposed in the welding carrier 2. As shown in FIG. 8, the magnets 21 should be distributed on at least two sides of the clearance 201. In a specific embodiment, the magnets 21 are permanent magnets.

In another typical embodiment, a difference from the foregoing embodiment lies in that, in the device for manufacturing the metal mask foil in the present disclosure, the press roll 4 in the foregoing embodiment is replaced with a vacuum device. The vacuum device is disposed in the welding carrier 2 and configured to provide a negative-pressure environment between the pieces of sub-foil 1 and the surface of the welding carrier 2. The vacuum device configured to provide a negative-pressure or vacuum environment is an existing technique, and details are not described herein.

In another typical embodiment, a difference from the foregoing embodiment lies in that, in the device for manufacturing the metal mask foil in the present disclosure, the press roll 4 in the foregoing embodiment is disposed, and the magnets 21 and/or the vacuum device are/is also disposed.

In another typical embodiment, a difference from the foregoing embodiment lies in that, in the device for manufacturing the metal mask foil in the present disclosure, the magnets 21 in the foregoing embodiment are disposed, and the vacuum device is also disposed.

The foregoing descriptions are merely specific implementations of the embodiments of the present invention, but are not intended to limit the protection scope of the embodiments of the present invention. Any change or replacement readily figured out by a person skilled in the art within the technical scope disclosed in the embodiments of the present invention shall fall within the protection scope of the embodiments of the present invention. Therefore, the protection scope of the embodiments of the present invention shall be subject to the protection scope of the claims.

## Claims

1. Metal mask foil, at least for manufacturing a metal mask used in OLED panel production, comprising:
at least two pieces of sub-foil (1), wherein the pieces of sub-foil (1) are disposed side by side in a width direction, and long edges in contact between two adjacent pieces of sub-foil (1) are welded together; and
a target width T of the metal mask foil and an average value t of initial widths of the pieces of sub-foil (1) meet: T/n ≤ t < T, n being a quantity of the pieces of sub-foil (1) that form the metal mask foil.

2. The metal mask foil according to claim 1, wherein the target width T of the metal mask foil is greater than or equal to 1 m, and a thickness is 0.02-0.5 mm.

3. The metal mask foil according to claim 1, wherein the metal mask foil is made of Invar36, SUS420, or SUS304, and is in a form of a sheet, a strip, or a coil.

4. A method for manufacturing the metal mask foil according to any one of claims 1 to 3, comprising:
taking at least two pieces of sub-foil (1);
cutting off an edge wave part of at least one long edge of each piece of sub-foil (1);
joining the pieces of sub-foil (1) together along long edges, wherein the pieces of sub-foil (1) are disposed side by side in a width direction and are joined tightly with no gap therebetween;
performing welding at each joining seam to form one whole piece of foil; and
cutting off excess parts of two long edges of the whole foil, to reach the target width T.

5. The method for manufacturing the metal mask foil according to claim 4, wherein if two long edges of sub-foil (1) that forms a middle part of the whole foil and a long edge that is close to an inner side and that is of sub-foil (1) that forms an edge part of the whole foil have edge waves, the edge waves are precut off before joining; and
if a long edge that is close to an outer side and that is of the sub-foil (1) that forms the edge part of the whole foil has an edge wave, the edge wave is precut off before joining or is cut off after welding.

6. The method for manufacturing the metal mask foil according to claim 4, wherein the joining seam is inspected before welding to ensure good joining at the joining seam.

7. The method for manufacturing the metal mask foil according to claim 4, wherein the welding step is implemented by one or more of laser welding, electron beam welding, resistance welding, and argon arc welding.

8. A device for manufacturing the metal mask foil according to any one of claims 1 to 3, comprising:
a welding carrier (2), provided with a clearance (201) in a middle part for keeping space during welding;
alignment mechanisms (3), wherein a plurality of alignment mechanisms (3) are arranged on two sides of the welding carrier (2) and are configured to push pieces of sub-foil (1) toward each other for joining, to ensure a tightly joining seam located exactly at the clearance (201);
a fitting component, configured to fit the pieces of sub-foil (1) to a surface of the welding carrier (2), to ensure that the pieces of sub-foil (1) are flush with each other in a thickness direction;
an inspection lens (5), configured to inspect a joining state at the joining seam; and
a welding heat source (6), configured to weld the pieces of sub-foil (1).

9. The device for manufacturing the metal mask foil according to claim 8, wherein flatness of the welding carrier (2) is less than or equal to 0.05 mm; and
a width of the clearance (201) is 1-5 mm.

10. The device for manufacturing the metal mask foil according to claim 8, wherein the fitting component comprises one or more of at least the following components:
a press roll (4), disposed on the welding carrier (2);
magnets (21), disposed in the welding carrier (2) and distributed on at least two sides of the clearance (201); and
a vacuum device, disposed in the welding carrier (2) and configured to provide a negative-pressure environment between the pieces of sub-foil (1) and the surface of the welding carrier (2).
